# EUROPEAN PATENT APPLICATION

(11) **EP 4 583 329 A1**
(43) Date of publication of application: **09.07.2025**
(21) Application number: 24852944.8
(22) Date of filing: 31.10.2024
(51) Int. Cl.: H01S 5/12

(54) **LOW-SENSITIVITY, LOW-DIVERGENCE-ANGLE SEMICONDUCTOR LIGHT-EMITTING DEVICE AND PREPARATION METHOD THEREFOR**

(30) Priority: 02.11.2023 CN 202311447840
(71) Applicant: Suzhou Everbright Photonics Co., Ltd., Suzhou, Jiangsu 215163 (CN); Everbright Institute of Semiconductor Photonics Co., Ltd., Suzhou, Jiangsu 215163 (CN)
(72) Inventor: WANG, Jun, Suzhou, Jiangsu 215163 (CN); XIAO, Yao, Suzhou, Jiangsu 215163 (CN); GAO, Yuanbin, Suzhou, Jiangsu 215163 (CN); MIAO, Pei, Suzhou, Jiangsu 215163 (CN); LIU, Heng, Suzhou, Jiangsu 215163 (CN); GUO, Shuai, Suzhou, Jiangsu 215163 (CN); ZHANG, Zhicheng, Suzhou, Jiangsu 215163 (CN); LI, Quanling, Suzhou, Jiangsu 215163 (CN)
(74) Representative: Lavoix
(86) International application number: PCT/CN2024/128989
(87) International publication number: WO 2025/092921

(57) **Abstract**

The present application discloses a low-sensitivity low-divergence-angle semiconductor light-emitting device and a manufacturing method therefor, wherein the low-sensitivity low-divergence-angle semiconductor light emitting device includes a substrate layer, and a first Bragg reflector, a resonant cavity and a second Bragg reflector which are sequentially stacked on one side of the substrate layer, wherein the resonant cavity includes at least three active area layers, a side, away from the substrate layer, of at least one among the active area layers is provided with an oxide limiting layer, a side, close to the substrate layer, of at least one among the active area layers adjacent to the oxide limitation layer is provided with a phase shift modulation layer, and a bandgap of a material of the phase shift modulation layer is higher than a bandgap of an energy corresponding to a wavelength of a laser light emitted by the low-sensitivity low-divergence-angle semiconductor light-emitting device. According to the low-sensitivity low-divergence-angle semiconductor light-emitting device and the manufacturing method therefor disclosed in the present application, a high gain is ensured while achieving a low divergence angle; and the environmental sensitivity of the semiconductor light-emitting device is reduced, and the production yield is improved.

## Description

### CROSS-REFERENCE TO RELATED APPLICATIONS

This application claims priority to Chinese patent application No. 202311447840.8, filed to the CNIPA on November 2, 2023, and entitled "Low-Sensitivity Low-Divergence-Angle Semiconductor Light-Emitting Device and Manufacturing Method therefor", the entire contents of which are incorporated herein by reference.

### TECHNICAL FIELD

The present application relates to the technical field of semiconductor lasers, in particular to a low-sensitivity low-divergence-angle semiconductor light-emitting device and a manufacturing method therefor.

### BACKGROUND

With the rapid development of artificial intelligence, more and more application scenarios require the use of high-quality sensing light sources to achieve finer perceptual recognition, which also brings great computing power requirements. Therefore, higher demands are placed on the capacity of optical communication.

The two most important application scenarios for vertical-cavity surface-emitting lasers (VCSELs) are sensor light sources and light sources for optical communication. In these application scenarios, a divergence angle is one of the most important properties affecting the performance of the vertical-cavity surface-emitting lasers. Therefore, development of VCSEL devices with an extremely low divergence angle is particularly important.

At present, it is very difficult for multi-junction vertical-cavity surface-emitting lasers to maintain a high power and a low divergence angle at the same time. First, in order to increase the power, more cascade junctions are usually used, as the number of junctions increases, the cavity length is correspondingly lengthened, and a corresponding optical confinement layer is also increased, so that small changes in an optical field all have a great influence on the divergence angle, so the structure cannot guarantee high power performance while realizing an extremely low divergence angle; secondly, the structure of the multi-junction vertical-cavity surface-emitting laser is very sensitive, in an epitaxial growth process and a manufacturing process (including processes such as etching, photolithography and coating), a slight deviation also easily affects the structure to cause variation in performance, which makes the requirement for control precision very high and the product yield low in the epitaxial growth process and the manufacturing process; and finally, in actual use, as the use conditions change, small changes in the optical field likewise cause changes in the divergence angle, affecting the use effect.

### SUMMARY OF THE INVENTION

To solve one or more of the above problems, the present application proposes a low-sensitivity low-divergence-angle semiconductor light-emitting device and a manufacturing method therefor.

According to an aspect of the present application, provided is a low-sensitivity low-divergence-angle semiconductor light-emitting device, including:
a substrate layer; and
a first Bragg reflector, a resonant cavity and a second Bragg reflector which are sequentially stacked on one side of the substrate layer, wherein
the resonant cavity includes at least three active area layers, adjacent active area layers are interconnected by a tunnel junction layer, and a side, away from the substrate layer, of at least one among the active area layers is provided with an oxide limiting layer, and
at least one among the active area layers provided with the oxide limiting layer is provided with a phase shift modulation layer on a side thereof close to the substrate layer; and
a bandgap of a material of the phase shift modulation layer is higher than a bandgap of an energy corresponding to a wavelength of a laser light emitted by the low-sensitivity low-divergence-angle semiconductor light-emitting device.

In some embodiments, a ratio of a peak value of an optical field intensity of the active area layer not provided with the phase shift modulation layer to a peak value of an optical field intensity of the active area layer provided with the phase shift modulation layer is greater than 3: 1 and not greater than 10: 1.

In some embodiments, an optical thickness of the phase shift modulation layer is in a range between 0.25 times and 1.25 times of the wavelength of the laser light emitted by the low-sensitivity low-divergence-angle semiconductor light-emitting device.

In some embodiments, a stress distribution of the material of the phase shift modulation layer is opposite to a stress distribution of a quantum well material.

In some embodiments, the phase shift modulation layer has a single-layer structure or a periodic distributed Bragg reflector (DBR) structure.

In some embodiments, when the resonant cavity includes N active area layers, N being an integer greater than or equal to 3, N-2 oxide limiting layers are provided, and the active area layers disposed between the first Bragg reflector and the second Bragg reflector are sequentially a first active area layer, ..., an (N-1)-th active area layer, and an Nth active area layer, wherein a side, away from the substrate layer, of the first active area layer and a side, away from the substrate layer, of the (N-1)-th active area layer are not provided with the oxide limiting layer.

According to another aspect of the present application, provided is a method for manufacturing a low-sensitivity low-divergence-angle semiconductor light-emitting device, configured to manufacture any one of the above low-sensitivity low-divergence-angle semiconductor light-emitting devices, and including the steps of:
providing a substrate layer, and
sequentially forming a first Bragg reflector, a resonant cavity, and a second Bragg reflector on one side of the substrate layer, wherein
the resonant cavity includes at least three active area layers, adjacent active area layers are interconnected by a tunnel junction layer, a side, away from the substrate layer, of at least one among the active area layers is provided with an oxide limiting layer, and at least one among the active area layers provided with the oxide limiting layer is provided with a phase shift modulation layer on a side thereof close to the substrate layer; and a bandgap of a material of the phase shift modulation layer is higher than a bandgap of an energy corresponding to a wavelength of a laser light emitted by the low-sensitivity low-divergence-angle semiconductor light-emitting device.

In some embodiments, a ratio of a peak value of an optical field intensity of the active area layer not provided with the phase shift modulation layer to a peak value of an optical field intensity of the active area layer provided with the phase shift modulation layer is greater than 3: 1 and not greater than 10: 1.

In some embodiments, an optical thickness of the phase shift modulation layer is in a range between 0.25 times and 1.25 times of the wavelength of the laser light emitted by the low-sensitivity low-divergence-angle semiconductor light-emitting device.

In some embodiments, a stress distribution of the material of the phase shift modulation layer is opposite to a stress distribution of a quantum well material.

According to the low-sensitivity low-divergence-angle semiconductor light-emitting device and the manufacturing method therefor disclosed in the present application, an active area provided with the oxide limiting layer is provided with the phase shift modulation layer, so that an optical field in the resonant cavity exhibits periodic high-low oscillation modulation. The modulated optical field has a low optical field intensity at a position of the active area where the phase shift modulation layer is disposed, and a high optical field intensity at a position of an active area where the phase shift modulation layer is not disposed, thereby ensuring a high gain while achieving a low divergence angle; the position of the active area with the phase shift modulation layer has a low optical field intensity, the ratio of the peak value of the optical field intensity of the active area layer without the phase shift modulation layer to the peak value of the optical field intensity of the active area layer with the phase shift modulation layer becomes larger, even if there is inaccurate epitaxy or process or external environment influencing optical field movement, coupled with the low optical field intensity of the active area layer where the phase shift modulation layer is disposed, the optical confinement of the whole system will not be greatly changed, thereby reducing environmental sensitivity of the semiconductor light-emitting device and improving the production yield; and the overall structural design starts from the epitaxial structure, without introducing new processes or other structural designs in the manufacturing process, without external control, and without generating additional production costs, improving the economy of the low-sensitivity low-divergence-angle semiconductor light-emitting device.

### BRIEF DESCRIPTION OF THE DRAWINGS

FIG 1 is a schematic structural diagram of a low-sensitivity low-divergence-angle semiconductor light-emitting device according to an embodiment of the present application.
FIG 2 is a schematic structural diagram of a low-sensitivity low-divergence-angle semiconductor light-emitting device according to another embodiment of the present application.
FIG 3 is a schematic diagram showing distribution of an optical field intensity and a refractive index of a low-sensitivity low-divergence-angle semiconductor light-emitting device according to an embodiment of the present application.
FIG 4 is a schematic diagram showing distribution of an optical field intensity and a refractive index of a conventional multi-junction semiconductor light-emitting device.

### DETAILED DESCRIPTION

In order to make the objects, technical solutions and advantages of the present application more clear, the present application is further described in detail below with reference to the accompanying drawings and embodiments. It should be understood that the specific embodiments described herein are some, but not all, embodiments of the present application, and are only intended to be illustrative of the present application, and not intended to limit the present application. Based on the embodiments in the present application, all other embodiments obtained by those of ordinary skill in the art without making inventive step belong to the scope of protection of the present application.

In the description of the present application, it should be noted that the orientation or position relationship indicated by the terms such as "center", "upper", "lower", "left", "right", "front", "back", "vertical", "horizontal", "inner", "outer", "both ends", "both sides", "bottom", and "top" is based on the orientation or position relationship shown in the drawings, only for the convenience of describing the present application and simplifying the description, rather than indicating or implying that the element referred to must have a specific orientation and be constructed and operated in a specific orientation, and therefore cannot be understood as a limitation of the present application. Moreover, the terms "first", "second", "superior", "subordinate", "primary", "secondary", and the like are used for descriptive purposes only and may be used simply to more clearly distinguish different components, and are not to be construed as indicating or implying relative importance.

**In** the description of the present application, it should be noted that unless expressly specified and defined otherwise, the terms "mounted", "connected", and "connection" should be broadly understood. For example, it can be fixed connection, detachable connection or integrated connection; it can be mechanical connection or electric connection; and it can be direct connection or indirect connection through an intermediate medium, and may be internal communication of two elements. The specific meanings of the above terms in the present application may be understood by those of ordinary skill in the art according to specific situations.

Furthermore, the technical features involved in the different embodiments of the present application described below may be combined with each other as long as they do not conflict with each other.

### Embodiment 1:

An embodiment of the present application provides a low-sensitivity low-divergence-angle semiconductor light-emitting device, including:
a substrate layer; and
a first Bragg reflector, a resonant cavity and a second Bragg reflector which are sequentially stacked on one side of the substrate layer, wherein
the resonant cavity includes at least three active area layers, adjacent active area layers are interconnected by a tunnel junction layer, and a side, away from the substrate layer, of at least one among the active area layers is provided with an oxide limiting layer, and
at least one among the active area layers provided with the oxide limiting layer is provided with a phase shift modulation layer on a side thereof close to the substrate layer; and
a bandgap of a material of the phase shift modulation layer should be higher than a bandgap of an energy corresponding to a wavelength of a laser light emitted by the low-sensitivity low-divergence-angle semiconductor light-emitting device.

In an optional embodiment, the phase shift modulation layer is disposed between stacked quantum wells of the active area layer. Therefore, the provision of the phase shift modulation layer between an N-DBR or P-DBR and the active area layer by disposing an elongated cavity is avoided, providing the elongated cavity has a very limited ability to adjust the optical field and cannot reduce the divergence angle while maintaining the same high gain, providing the elongated cavity needs to move the optical field towards the elongated cavity so that an optical field intensity of the active area is very low, coupling is low and the gain is not sufficient; by inserting the phase shift modulation layer between the cascaded active area layers, the gain is high or low and the average value is high, while the optical field intensity is reduced in a region where the oxide limiting layer is disposed, reducing the effect of the oxide limiting layer on the divergence angle, and the sensitivity.

In an optional embodiment, when the resonant cavity includes N active area layers, N being an integer greater than or equal to 3, N-2 oxide limiting layers are provided, and the active area layers disposed between the first Bragg reflector and the second Bragg reflector are sequentially a first active area layer, ..., an (N-1)-th active area layer, and an Nth active area layer, wherein a side, away from the substrate layer, of the first active area layer and a side, away from the substrate layer, of the (N-1)-th active area layer are not provided with the oxide limiting layer.

At least one phase shift modulation layer should be provided, and the number of the phase shift modulation layers does not exceed N-2;
when only one phase shift modulation layer is provided, the phase shift modulation layer should be disposed on a side, close to the substrate layer, of the N-th active area layer; and
when the number of the phase shift modulation layers is n, n being an integer greater than 1 and not greater than N-2, N should be an integer greater than or equal to 4, two of the phase shift modulation layers should be disposed on sides, close to the substrate layer, of the second active area layer and the N-th active area layer, and other phase shift modulation layers may be disposed on sides, close to the substrate layer, of any n-2 active area layers among the third active area layer to the (N-1)-th active area layer.

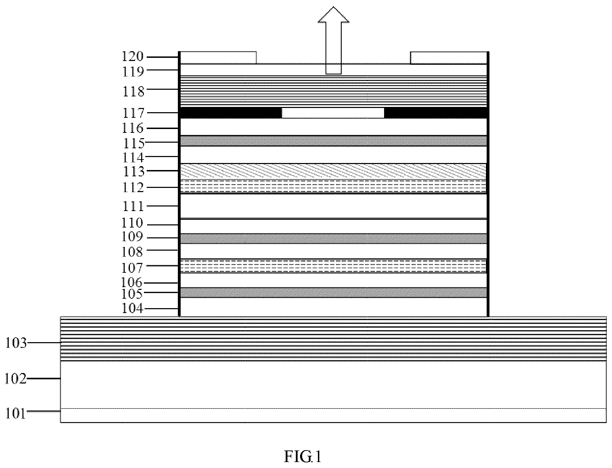

Referring to FIG 1 in the drawings, taking three active area layers as an example, a low-sensitivity low-divergence-angle semiconductor light-emitting device includes:
a substrate layer 102; and
a first Bragg reflector 103, a resonant cavity and a second Bragg reflector 118 which are sequentially stacked on one side of the substrate layer 102, wherein
the resonant cavity includes a first active area layer 105, a second active area layer 109 and a third active area layer 115;
wherein a first tunnel junction layer 107 is disposed between the first active area layer 105 and the second active area layer 109, and a second tunnel junction layer 112 is disposed between the second active area layer 109 and the third active area layer 115;
a side, away from the substrate layer 102, of the third active area layer 115 is provided with a first oxide limiting layer 117; and
a side, close to the substrate layer 102, of the third active area layer 115 is provided with a first phase shift modulation layer 113.

A bandgap of a material of the first phase shift modulation layer 113 is higher than a bandgap of an energy corresponding to a wavelength of a laser light emitted by the low-sensitivity low-divergence-angle semiconductor light-emitting device.

**In** particular, the first phase shift modulation layer 113 may be made of an aluminum gallium arsenide material, or a combination of aluminum gallium arsenide materials having different refractive indices.

Therefore, the oxide limiting layer is disposed within the resonant cavity, enhancing confinement of a current and an optical field, achieving high-power and low-threshold laser output, and the phase shift modulation layer corresponding to the oxide limiting layer is disposed within the resonant cavity, causing the optical field within the resonant cavity to exhibit an envelope of oscillatory changes, generating periodic high-low oscillation modulation of the optical field within the resonant cavity, the optical field intensity at the oxide limiting layer after modulation is very low, and even if there is inaccurate epitaxy or process or external environment influencing the optical field movement, coupled with the low optical field intensity at the oxide limiting layer, the optical confinement of the whole system will not be greatly changed, thereby reducing the sensitivity of the device and ensuring the production yield; compared with the structure without the phase shift modulation layer, the same number of oxide limiting layers is used, but the semiconductor light-emitting device provided by the present application has a lower optical field limiting capability, and can achieve a lower divergence angle, even if the number of the oxide limiting layers is increased, the optical confinement will not be increased, and a lower divergence angle can be maintained while achieving high power output.

In an optional embodiment, an optical thickness of the first phase shift modulation layer 113 is in a range between 0.25 times and 1.25 times of the wavelength of the laser light emitted by the low-sensitivity low-divergence-angle semiconductor light-emitting device. Thus, the optical field can be modulated without greatly increasing the thickness of the resonant cavity.

In an optional embodiment, in the resonant cavity provided with the phase shift modulation layer, a ratio of a peak value of an optical field intensity of the active area layer not provided with the phase shift modulation layer to a peak value of an optical field intensity of the active area layer provided with the phase shift modulation layer is greater than 3:1 and not greater than 10: 1. Thus, the sensitivity of the device can be ensured to be very low while a sufficiently high gain can be ensured since the sum of optical confinement factors of the active areas in the cavity after the addition of the phase shift modulation layer is greater than optical confinement factors of the active areas in the cavity without the addition of the phase shift modulation layer. If the ratio of the peak value of the optical field intensity of the active area layer not provided with the phase shift modulation layer to the peak value of the optical field intensity of the active area layer provided with the phase shift modulation layer is less than 3: 1, then the decrease in the optical field intensity of the active area provided with the phase shift modulation layer is too small, the divergence angle is still very sensitive to external environmental conditions such as epitaxial growth, the manufacturing process and the device working environment, and the sensitivity of the device cannot be effectively reduced, and if the ratio of the peak value of the optical field intensity of the active area layer not provided with the phase shift modulation layer to the peak value of the optical field intensity of the active area layer provided with the phase shift modulation layer is greater than 10:1, then the decrease in the optical field intensity of the active area provided with the phase shift modulation layer is too large, causing an optical field intensity of the active area adjacent to the phase shift modulation layer to be very low, and a very low gain, resulting in low luminous efficiency, and the active area provided with the phase shift modulation layer may even become an absorption loss layer, affecting device performance.

In an optional embodiment, a stress distribution of the material of the first phase shift modulation layer 113 is opposite to a stress distribution of a quantum well material. Thus, the function of supplementing the reverse stress can be achieved, making the structure of the semiconductor light-emitting device more stable.

In an optional embodiment, the first phase shift modulation layer 113 has a single-layer structure or a periodic distributed Bragg reflector (DBR) structure.

The low-sensitivity low-divergence-angle semiconductor light-emitting device further includes a first electrode 101 disposed on a side, away from the first Bragg reflector 103, of the substrate layer 102.

The low-sensitivity low-divergence-angle semiconductor light-emitting device further includes an ohmic contact layer 119 disposed on a side, away from the substrate layer 102, of the second Bragg reflector 118, and a second electrode 120 disposed on a side, away from the second Bragg reflector 118, of the ohmic contact layer.

In this embodiment, a first waveguide layer 104 is disposed between the first active area layer 105 and the first Bragg reflector 103, a second waveguide layer 106 is disposed between the first active region layer 105 and the first tunnel junction layer 107, a third waveguide layer 108 is disposed between the first tunnel junction layer 107 and the second active area layer 109, a side, away from the third waveguide layer 108, of the second active area layer 109 is provided with a fourth waveguide layer 110, a fifth waveguide layer 111 is disposed between the second tunnel junction layer 112 and the fourth waveguide layer 110, a sixth waveguide layer 114 is disposed between the first phase shift modulation layer 113 and the third active area layer 115, and a seventh waveguide layer 116 is disposed between the third active area layer 115 and the first oxide limiting layer 117.

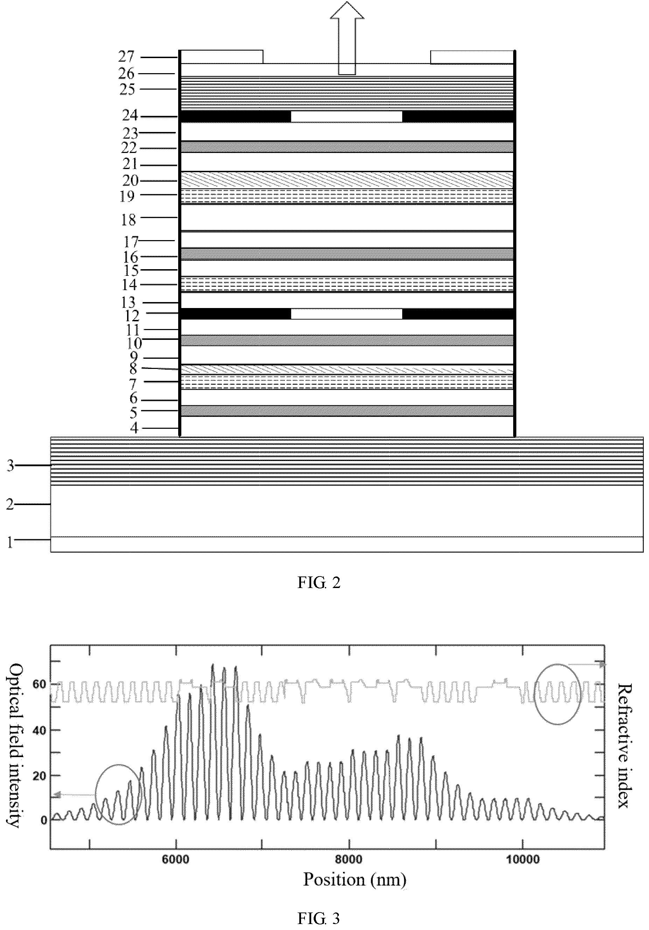

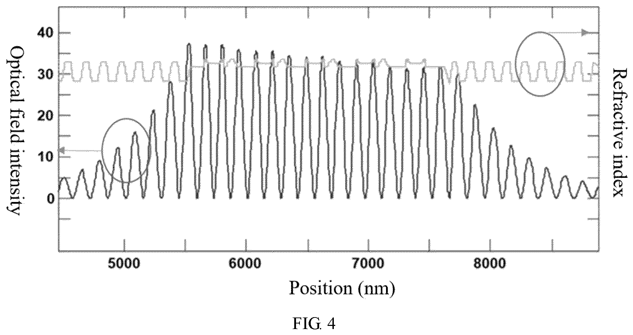

Referring to FIGS. 3 and 4 in the drawings, a schematic diagram showing distribution of an optical field intensity and a refractive index of the low-sensitivity low-divergence-angle semiconductor light-emitting device provided by the embodiment of the present application and a schematic diagram showing distribution of an optical field intensity and a refractive index of the conventional multi-junction semiconductor light-emitting device are shown respectively. **In** the drawings, a black line represents a curve of the optical field intensity as a function of the position and a gray line represents a curve of the refractive index as a function of the position, which are distinguished by arrow pointing. According to FIGS. 3 and 4 in the drawings, it can be seen that in the semiconductor light-emitting device provided with the phase shift modulation layer, the optical field intensity of the active area layer provided with the phase shift modulation layer is obviously reduced, thereby achieving a low divergence angle while reducing the sensitivity of the device on the premise of ensuring a sufficiently high gain.

The low-sensitivity low-divergence-angle semiconductor light-emitting device disclosed in the present application has the beneficial effects: the phase shift modulation layer is disposed, so that an optical field in the resonant cavity exhibits periodic high-low oscillation modulation. The modulated optical field has a low optical field intensity at a position of the active area where the phase shift modulation layer is disposed, and a high optical field intensity at a position of an active area where the phase shift modulation layer is not disposed, thereby ensuring a high gain while achieving a low divergence angle; the position of the active area with the phase shift modulation layer has a low optical field intensity, the ratio of the peak value of the optical field intensity of the active area layer without the phase shift modulation layer to the peak value of the optical field intensity of the active area layer with the phase shift modulation layer becomes larger, even if there is inaccurate epitaxy or process or external environment influencing optical field movement, coupled with the low optical field intensity of the active area layer where the phase shift modulation layer is disposed, the optical confinement of the whole system will not be greatly changed, thereby reducing environmental sensitivity of the semiconductor light-emitting device and improving the production yield; and the overall structural design starts from the epitaxial structure, without introducing new processes or other structural designs in the manufacturing process, without external control, and without generating additional production costs, reducing the production difficulty, reducing manufacturing costs, and improving the economy of the low-sensitivity low-divergence-angle semiconductor light-emitting device.

### Embodiment 2:

Referring to FIG 2 in the drawings, taking four active area layers as an example, a low-sensitivity low-divergence-angle semiconductor light-emitting device includes:
a substrate layer 2; and
a first Bragg reflector 3, a resonant cavity and a second Bragg reflector 25 which are sequentially stacked on one side of the substrate layer 2, wherein
the resonant cavity includes a first active area layer 5, a second active area layer 10, a third active area layer 16 and a fourth active area layer 22;
wherein a first tunnel junction layer 7 is disposed between the first active area layer 5 and the second active area layer 10, a second tunnel junction layer 14 is disposed between the second active area layer 10 and the third active area layer 16, and a third tunnel junction layer 19 is disposed between the third active area layer 16 and the fourth active area layer 22;
a side, away from the substrate layer 2, of the second active area layer 10 is provided with a first oxide limiting layer 12, and a side, away from the substrate layer 1, of the fourth active area layer 22 is provided with a second oxide limiting layer 24; and
a side, close to the substrate layer 1, of the second active area layer 10 is provided with a first phase shift modulation layer 8, and a side, close to the substrate layer 1, of the fourth active area layer 22 is provided with a second phase shift modulation layer 20.

A bandgap of a material of the first phase shift modulation layer 8 and a bandgap of a material of the second phase shift modulation layer 20 are higher than a bandgap of an energy corresponding to a wavelength of a laser light emitted by the low-sensitivity low-divergence-angle semiconductor light-emitting device.

The low-sensitivity low-divergence-angle semiconductor light-emitting device further includes a first electrode 1 disposed on a side, away from the first Bragg reflector 3, of the substrate layer 2.

The low-sensitivity low-divergence-angle semiconductor light-emitting device further includes an ohmic contact layer 26 disposed on a side, away from the substrate layer 2, of the second Bragg reflector 25, and a second electrode 27 disposed on a side, away from the second Bragg reflector 25, of the ohmic contact layer 26.

In this embodiment, a first waveguide layer 4 is disposed between the first active area layer 5 and the first Bragg reflector 3, a second waveguide layer 6 is disposed between the first active area layer 5 and the first tunnel junction layer 7, a third waveguide layer 9 is disposed between the first phase shift modulation layer 8 and the second active area layer 10, a fourth waveguide layer 11 is disposed between the second active area layer 10 and the second oxide limiting layer 12, a fifth waveguide layer 13 is disposed between the first oxide limiting layer 12 and the second tunnel junction layer 14, a sixth waveguide layer 15 is disposed between the second tunnel junction layer 14 and the third active area layer 16, a side, away from the substrate layer 2, of the third active area layer 16 is provided with a seventh waveguide layer 17, an eighth waveguide layer 18 is disposed between the seventh waveguide layer 17 and the third tunnel junction layer 19, a ninth waveguide layer 21 is disposed between the second phase shift modulation layer 20 and the fourth active area layer 22, and a tenth waveguide layer 23 is disposed between the fourth active area layer 22 and the second oxide limiting layer 24.

Parts of this embodiment that are the same as those of Embodiment 1 will not be described in detail here.

### Embodiment 3:

An embodiment of the present application further provides a method for manufacturing a low-sensitivity low-divergence-angle semiconductor light-emitting device, configured to manufacture any one of the low-sensitivity low-divergence-angle semiconductor light-emitting devices in the above embodiments, and including the steps of:
providing a substrate layer, and
sequentially forming a first Bragg reflector, a resonant cavity, and a second Bragg reflector on one side of the substrate layer, wherein
the resonant cavity includes at least three active area layers, adjacent active area layers are interconnected by a tunnel junction layer, a side, away from the substrate layer, of at least one among the active area layers is provided with an oxide limiting layer, and at least one among the active area layers provided with the oxide limiting layer is provided with a phase shift modulation layer on a side thereof close to the substrate layer; and a bandgap of a material of the phase shift modulation layer is higher than a bandgap of an energy corresponding to a wavelength of a laser light emitted by the low-sensitivity low-divergence-angle semiconductor light-emitting device.

In an optional embodiment, a ratio of a peak value of an optical field intensity of the active area layer not provided with the phase shift modulation layer to a peak value of an optical field intensity of the active area layer provided with the phase shift modulation layer is greater than 3: 1 and not greater than 10: 1.

In an optional embodiment, an optical thickness of the phase shift modulation layer is in a range between 0.25 times and 1.25 times of the wavelength of the laser light emitted by the low-sensitivity low-divergence-angle semiconductor light-emitting device.

In an optional embodiment, a stress distribution of the material of the phase shift modulation layer is opposite to a stress distribution of a quantum well material.

In an optional embodiment, the phase shift modulation layer has a single-layer structure or a periodic distributed Bragg reflector (DBR) structure.

Parts of this embodiment that are the same as those of Embodiment 1 will not be described in detail here.

The method for manufacturing the low-sensitivity low-divergence-angle semiconductor light-emitting device disclosed in the present application has the beneficial effects: the phase shift modulation layer is disposed, so that an optical field in the resonant cavity exhibits periodic high-low oscillation modulation. The modulated optical field has a low optical field intensity at a position of the active area where the phase shift modulation layer is disposed, and a high optical field intensity at a position of an active area where the phase shift modulation layer is not disposed, thereby ensuring a high gain while achieving a low divergence angle; the position of the active area with the phase shift modulation layer has a low optical field intensity, the ratio of the peak value of the optical field intensity of the active area layer without the phase shift modulation layer to the peak value of the optical field intensity of the active area layer with the phase shift modulation layer becomes larger, even if there is inaccurate epitaxy or process or external environment influencing optical field movement, coupled with the low optical field intensity of the active area layer where the phase shift modulation layer is disposed, the optical confinement of the whole system will not be greatly changed, thereby reducing environmental sensitivity of the semiconductor light-emitting device and improving the production yield; and the overall structural design starts from the epitaxial structure, without introducing new processes or other structural designs in the manufacturing process, without external control, and without generating additional production costs, improving the economy of the low-sensitivity low-divergence-angle semiconductor light-emitting device.

The above are merely optional embodiments of the present application, and it should be noted that for those of ordinary skill in the art, several improvements and modifications can be made without departing from the principles of the present application, and these improvements and modifications should also be regarded as the scope of protection of the present application.

## Claims

1. A low-sensitivity low-divergence-angle semiconductor light-emitting device, **characterized in** comprising:
a substrate layer; and
a first Bragg reflector, a resonant cavity and a second Bragg reflector which are sequentially stacked on one side of the substrate layer, wherein
the resonant cavity comprises at least three active area layers, adjacent active area layers are interconnected by a tunnel junction layer, and a side, away from the substrate layer, of at least one among the active area layers is provided with an oxide limiting layer, and
at least one among the active area layers provided with the oxide limiting layer is provided with a phase shift modulation layer on a side thereof close to the substrate layer; and
a bandgap of a material of the phase shift modulation layer is higher than a bandgap of an energy corresponding to a wavelength of a laser light emitted by the low-sensitivity low-divergence-angle semiconductor light-emitting device.

2. The low-sensitivity low-divergence-angle semiconductor light-emitting device according to claim 1, **characterized in that**, a ratio of a peak value of an optical field intensity of the active area layer not provided with the phase shift modulation layer to a peak value of an optical field intensity of the active area layer provided with the phase shift modulation layer is greater than 3: 1 and not greater than 10: 1.

3. The low-sensitivity low-divergence-angle semiconductor light-emitting device according to claim 1, **characterized in that**, an optical thickness of the phase shift modulation layer is in a range between 0.25 times and 1.25 times of the wavelength of the laser light emitted by the low-sensitivity low-divergence-angle semiconductor light-emitting device.

4. The low-sensitivity low-divergence-angle semiconductor light-emitting device according to claim 1, **characterized in that**, a stress distribution of the material of the phase shift modulation layer is opposite to a stress distribution of a quantum well material.

5. The low-sensitivity low-divergence-angle semiconductor light-emitting device according to claim 1, **characterized in that**, the phase shift modulation layer has a single-layer structure or a periodic distributed Bragg reflector (DBR) structure.

6. The low-sensitivity low-divergence-angle semiconductor light-emitting device according to claim 1, **characterized in that**, when the resonant cavity comprises N active area layers, N being an integer greater than or equal to 3, N-2 oxide limiting layers are provided, and the active area layers disposed between the first Bragg reflector and the second Bragg reflector are sequentially a first active area layer, ..., an (N-1)th active area layer, and an Nth active area layer, wherein a side, away from the substrate layer, of the first active area layer and a side, away from the substrate layer, of the (N-1)th active area layer are not provided with the oxide limiting layer.

7. A method for manufacturing a low-sensitivity low-divergence-angle semiconductor light-emitting device, configured to manufacture the low-sensitivity low-divergence-angle semiconductor light-emitting device according to any one of claims 1-6, **characterized in** comprising the steps of:
providing a substrate layer, and
sequentially forming a first Bragg reflector, a resonant cavity, and a second Bragg reflector on one side of the substrate layer, wherein
the resonant cavity comprises at least three active area layers, adjacent active area layers are interconnected by a tunnel junction layer, a side, away from the substrate layer, of at least one among the active area layers is provided with an oxide limiting layer, and at least one among the active area layers provided with the oxide limiting layer is provided with a phase shift modulation layer on a side thereof close to the substrate layer; and a bandgap of a material of the phase shift modulation layer is higher than a bandgap of an energy corresponding to a wavelength of a laser light emitted by the low-sensitivity low-divergence-angle semiconductor light-emitting device.

8. The method for manufacturing the low-sensitivity low-divergence-angle semiconductor light-emitting device according to claim 7, **characterized in that**, a ratio of a peak value of an optical field intensity of the active area layer not provided with the phase shift modulation layer to a peak value of an optical field intensity of the active area layer provided with the phase shift modulation layer is greater than 3: 1 and not greater than 10: 1.

9. The method for manufacturing the low-sensitivity low-divergence-angle semiconductor light-emitting device according to claim 7, **characterized in that**, an optical thickness of the phase shift modulation layer is in a range between 0.25 times and 1.25 times of the wavelength of the laser light emitted by the low-sensitivity low-divergence-angle semiconductor light-emitting device.

10. The method for manufacturing the low-sensitivity low-divergence-angle semiconductor light-emitting device according to claim 7, **characterized in that**, a stress distribution of the material of the phase shift modulation layer is opposite to a stress distribution of a quantum well material.
